# EUROPÄISCHE PATENTSCHRIFT

(11) **EP 1 524 890 B1**
(45) Veröffentlichungstag und Bekanntmachung des Hinweises auf die Patenterteilung: **27.09.2006**
(21) Anmeldenummer: 03023524.6
(22) Anmeldetag: 15.10.2003
(51) Int. Cl.: H05K 7/14

(54) **Wechsel von elektrischen Baugruppen bei stehender Verdrahtung**
Electronic modules exchange with permanent wiring
Remplacement de modules électriques au câblage fixe

(43) Veröffentlichungstag der Anmeldung: 20.04.2005
(73) Patentinhaber: SIEMENS AKTIENGESELLSCHAFT, 80333 München (DE)
(72) Erfinder: Bergmann, Martin, 92253 Schnaittenbach (DE)

(56) Entgegenhaltungen:
- EP-A- 0 599 551
- DE-A- 4 328 813
- US-A- 6 147 877
- US-B1- 6 172 875
- US-B1- 6 468 092

## Beschreibung

Die Erfindung betrifft eine elektrische Baugruppe, eine Trägerplatte und ein System zum einfachen Auswechseln von Elektronikmodulen, insbesondere bei dezentralen Peripheriebaugruppen eines Automatisierungssystems, bei stehender Verdrahtung.

Elektrische bzw. elektronische Baugruppen, insbesondere solche in der dezentralen Peripherie, sind in der Regel auf einer Trägerplatte bzw. auf einem Terminalmodul fixiert und an ein Bussystem zur Kommunikation angeschlossen. Die Baugruppen weisen zur Verbindung mit Feldgeräten, beispielsweise Sensoren und Aktoren, die Rahmen eines Automatisierungssystems für die Prozesssteuerung verantwortlich sind, in der Regel Steckverbindungen für die Signalein- und Signalausgänge auf. Im Rahmen eines Automatisierungssystems müssen die elektrischen bzw. elektronischen Baugruppen mitunter ausgewechselt werden. Hierzu ist neben dem Lösen der Steckverbindungen für die Endgeräte ein Auswechseln unter Umständen vorhandener Kennzeichnungsschilder am Gehäuse der Baugruppen vonnöten. Bei einem Austausch einer Baugruppe besteht somit die Gefahr, dass sowohl die Kennzeichnungsschilder als auch die Steckverbinder nach Einbau der neuen Baugruppe verwechselt bzw. an falsche Positionen gesetzt werden. Es hat sich gezeigt, dass die Fehlersuche in solch einem Fall sich im Allgemeinen als sehr schwierig erweist.

Aus der US 6 468 092 ist ein System bekannt, bei dem eine Baugruppe aus einem elektronischen Teil und einem Adapter besteht, wobei der Adapter über Ein- und Ausgänge für die Steckverbindungen zu den Feldgeräten verfügt und den elektronischen Teil nach außen hin abschirmt. Der elektronische Teil der Baugruppe kann ausgewechselt werden, ohne dass die Steckverbindungen vom Adapter gelöst werden müssen.

Aus der US 6 147 877 ist eine Anordnung bekannt, bei der eine Baugruppe von einem auf einem Terminalmodul aufsitzendem Steckermodul abgezogen werden kann, wobei die Steckverbindungen nicht gelöst werden müssen.

Die Aufgabe der vorliegenden Erfindung besteht darin, ein verbessertes System zum Auswechseln einer elektrischen bzw. elektronischen Baugruppe anzugeben.

Die Aufgabe wird gelöst durch eine elektrische Baugruppe, insbesondere Baugruppe einer dezentralen Peripherie eines Automatisierungssystems, zur Befestigung auf einer Trägerplatte, mit einem Elektronikmodul und mit einem mit dem Elektronikmodul koppelbaren Steckermodul zum Herstellen mindestens einer Steckverbindung, dadurch gekennzeichnet, dass das Steckermodul an einem Ende ein Lager zum Einhängen des Steckermoduls in eine Einhängevorrichtung der Trägerplatte aufweist, wodurch die elektrische Baugruppe von der Trägerplatte um den Drehpunkt der Einhängevorrichtung wegschwenkbar ist.

Der Erfindung liegt die Erkenntnis zugrunde, dass beim Auswechseln von Elektronikmodulen, insbesondere im Rahmen der dezentralen Peripherie eines Automatisierungssystems, Verwechslungen bezüglich der Steckerverbindungen zu den Feldgeräten sowie auch der Kennzeichnungsschilder auftreten können. Das Beheben dieser Fehler kostet in der Regel Zeit und ist relativ aufwändig und schwierig. Im Rahmen der vorliegenden Erfindung kann eine Baugruppe bzw. das Elektronikmodul einer Baugruppe auf einfache Weise ausgewechselt werden. Dadurch, dass ein Steckermodul mit dem Elektronikmodul gekoppelt ist und das Steckermodul zum Wechseln des Elektronikmoduls jedoch von der Trägerplatte wegschwenkbar ist, kann das mit dem Steckermodul gekoppelte Elektronikmodul der Baugruppe ausgewechselt werden, ohne dass das Steckermodul vollständig von der Trägerplatte gelöst werden muss. Wird das Steckermodul von der Trägerplatte weggeschwenkt, so dreht es sich um den Drehpunkt der Einhängevorrichtung und verbleibt trotz der Schwenkbewegung am Terminalmodul. Hierbei verbleibt das schwenkbare Steckermodul am Terminalmodul. Die Steckverbindungen zu den Feldgeräten sowie gegebenenfalls vorhandene Kennzeichnungsschilder auf dem Steckermodul müssen nicht ausgewechselt werden. Ein Fehler bei falscher Zuordnung der Steckverbindungen nach Austausch des Elektronikmoduls unterbleibt somit. Ein einfaches, fehlerfreies Austauschen der Elektronikmodule bzw. Baugruppen im Rahmen der dezentralen Peripherie wird hierdurch möglich.

Eine weitere vorteilhafte Ausbildung der Erfindung ist dadurch gekennzeichnet, dass das Elektronikmodul derart ausgestaltet ist, dass es auf dem Steckermodul aufsitzend während des Schwenkvorgangs am Steckermodul verbleibt und dass das Elektronikmodul derart ausgestaltet ist, dass es nach Beendigung des Schwenkvorgangs vom Steckermodul abziehbar ist. Nachdem das Steckermodul von der Trägerplatte weggeschwenkt ist, liegt das Elektronikmodul frei, ist jedoch mit dem Steckermodul noch gekoppelt. Durch eine formschlüssig ausgestaltete Verbindung zwischen Steckermodul und Elektronikmodul ist es möglich, das Elektronikmodul vom Steckermodul abzuziehen. Hierbei gleitet das Elektronikmodul quasi aus dem formgebenden Bett des Steckermoduls heraus. Vorteilhaft ist bei dieser Ausgestaltung, dass das Elektronikmodul nach Wegschwenken des Steckermoduls erst mal noch in einer definierten und sicheren Position verbleibt, gleichzeitig aber freier Zugang besteht, so dass das Elektronikmodul entnommen und gewechselt werden kann. Beim umgekehrten Vorgang des Einsetzens eines Elektronikmoduls wird Selbiges dann wieder in das Steckermodul eingeschoben.

Eine weitere vorteilhafte Ausbildung der Erfindung ist dadurch gekennzeichnet, dass das Lager des Steckermoduls als Drehlager ausgebildet ist und dass das Steckermodul nach Beendigung des Schwenkvorgangs zur Einnahme einer definierten Endposition vorgesehen ist. Das Drehlager am Steckermodul bzw. an der Baugruppe gibt definierte Einbauverhältnisse vor, d.h. die Baugruppe wird beim Einsetzen in das Profil an der Trägerplatte, also in die Einhängevorrichtung vorgeführt und gibt bei der Montage die erforderliche Abstützung. Aus diesem Grund können für die Befestigung der Baugruppe weitere Schrauben entfallen. Eine Fixierung der Position erfolgt bereits durch das Drehlager. Beim Austausch der Baugruppe bzw. des Elektronikmoduls geht das Steckermodul in eine definierte Endlage. Das Steckermodul nimmt in dieser Endlage eine stabile Position an der Trägerplatte ein, so dass das Elektronikmodul einfach und sicher gewechselt werden kann.

Eine weitere vorteilhafte Ausbildung der Erfindung ist dadurch gekennzeichnet, dass das Lager des Steckermoduls am unteren Ende des Steckermoduls ausgebildet ist, wodurch die elektrische Baugruppe nach unten von der Trägerplatte wegschwenkbar ist. Hierdurch erübrigt sich in der Regel das Vorhalten zusätzlicher Kabellängen beispielsweise auf der Aktor/Sensor Seite, da die Anschlüsse dem System in den meisten Fällen von unten her zugeführt werden und das Steckermodul in seiner Endlage dem angeschlossenen Feldgerät quasi entgegenkommt, so dass keine Kabellängenreserve für das Wechseln benötigt wird.

Es ist jedoch auch vorstellbar, dass in einer weiteren Ausführung der Erfindung die Steckermodule und damit die Baugruppen nach oben wegschwenkbar sind, indem das Lager oben am Steckverbinder angeordnet ist. In der stabilen Endposition an der Trägerplatte rasten die Steckermodule dann in einer Einrastvorrichtung ein und ein Wechseln des Elektronikmoduls kann ebenfalls durch Rausziehen des Moduls in dieser Stabilen Lage erfolgen. Diese vorteilhaft Ausgestaltung der Erfindung ist besonders günstig einzusetzen, wenn die Anschlüsse dem System von oben her zugeführt werden.

Vorteilhaft ist im Rahmen des gesamten Auswechselns einer derartigen elektrischen Baugruppen vor allem, dass neben der einfachen Bedienbarkeit während des gesamten Vorgangs die Steckverbindungen am Steckermodul zu den entsprechenden Feldgeräten des Automatisierungssystems nicht gelöst werden müssen. Ebenso können gegebenenfalls vorhandene Kennzeichnungsschilder an dem Steckermodul verbleiben.

Eine weitere vorteilhafte Ausbildung der Erfindung ist dadurch gekennzeichnet, dass eine Trägerplatte zur Aufnahme einer aus einem mit einem Elektronikmodul koppelbaren Steckermodul bestehenden elektrischen Baugruppe, insbesondere einer Baugruppe der dezentralen Peripherie eines Automatisierungssystems, dadurch gekennzeichnet, dass die Trägerplatte eine Einhängevorrichtung zum Einhängen mindestens eines Steckermoduls aufweist, wobei das Steckermodul derart ausgestaltet ist, dass die elektrische Baugruppe von der Trägerplatte um den Drehpunkt der Einhängevorrichtung wegschwenkbar ist und dass die Einhängevorrichtung der Trägerplatte als Drehlager ausgebildet ist. Wird das Steckermodul einer elektrischen Baugruppe somit von der Trägerplatte weggeschwenkt, hängt es an einem Ende nach wie vor in der Einhängevorrichtung der Trägerplatte. Hierdurch ist das Steckermodul zwar beweglich schwenkbar, kann aber zum Wechseln eines Elektronikmoduls der Baugruppe an seiner Position im Rahmen des Terminalmoduls bzw. der Trägerplatte verbleiben. Muss das Steckermodul jedoch ganz ausgetauscht werden, so kann es auf einfache Weise ganz aus dem Lager ausgeschwenkt werden, ohne dass weitere Manipulation durch den Monteur nötig wäre. Insbesondere sind keine weiteren Schraubverbindungen zum Lösen des Steckermoduls zu betätigen.

Im Folgenden wird die Erfindung anhand der Figuren näher beschrieben und erläutert.

Es zeigen:
- Figur 1: eine schematische Darstellung eines Systems zum Wechseln einer elektrischen Baugruppe,
- Figur 2 bis 4: eine elektrische Baugruppe in verschiedenen Schwenk-Positionen an einer Trägerplatte.

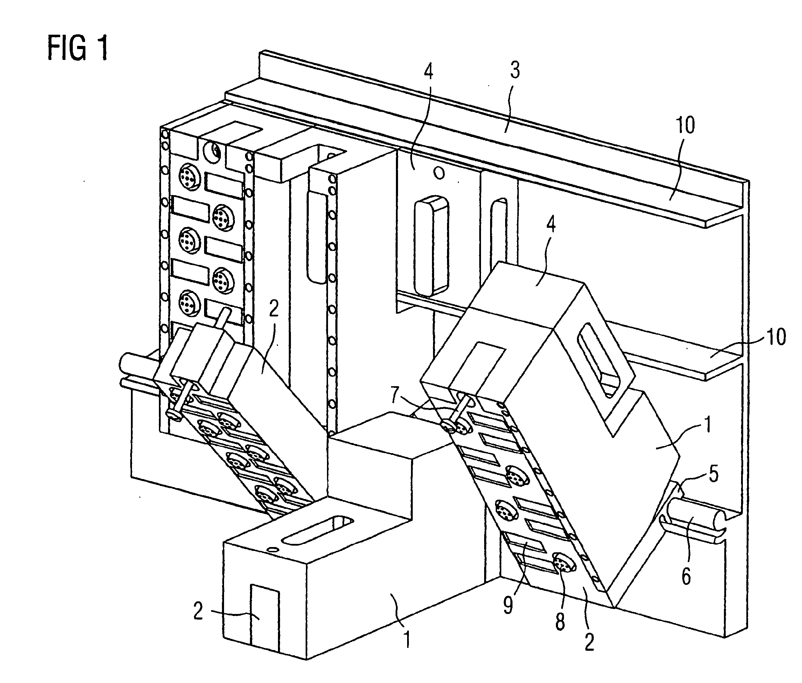

Die Figur 1 stellt eine Trägerplatte 3 dar, auf der elektrische Baugruppen 1,2, jeweils bestehend aus einem Elektronikmodul 1 und einem Steckermodul 2, befestigt werden. Die Trägerplatte 3 verfügt über ein Profil 10, zur Befestigung eines Busmoduls 4. Das Busmodul 4 ist direkt an der Trägerplatte 3 angebracht oder sitzt auf der Baugruppe 1,2 auf. Über eine Schnittstelle 14 ist das Busmodul mit dem Elektronikmodul 1 der elektrischen Baugruppe 1,2 verbunden. Das Steckermodul 2 verfügt über ein Lager 5, über das das Steckermodul 2 in eine Einhängevorrichtung 6 der Trägerplatte 3 eingehängt werden kann. Das Steckermodul 2 ist formschlüssig mit dem Elektronikmodul 1 verbunden. Das Steckermodul 2 verfügt über mehrere Ein- und Ausgänge bzw. Verbindungsmöglichkeiten 8 für Feldgeräte und über Schilder 9 zur Beschriftung der Ein- und Ausgänge. Das Steckermodul 2 ist über eine Schnittstelle mit dem Elektronikmodul 1 verbunden. Vorzugsweise an dem dem Lager 5 gegenüberliegenden Ende des Steckermoduls 2 wird das Steckermodul durch ein Befestigungsmittel 7, insbesondere durch eine Schraube, an der Trägerplatte 3 befestigt.

Das Steckermodul 2 kann zum Austausch des Elektronikmoduls 1 von der Trägerplatte 3 weggeschwenkt werden. Das Elektronikmodul 1 liegt nun frei aufsitzend an dem weggeschwenkten Steckermodul 2, ist jedoch durch die formschlüssige Verbindung mit dem Steckermodul 2 noch derart fest gehalten, dass es nicht herunter rutschen kann. Das Elektronikmodul 1 kann in der weggeschwenkten Lage jedoch vom Steckermodul 2 abgezogen werden. Hierbei wird dann auch die elektrische Verbindung über die Schnittstelle, die das Elektronikmodul 1 mit dem Steckermodul 2 verbindet, unterbrochen. Insbesondere die Steckverbinder 8 zu den Feldgeräten können am Steckermodul 2 verbleiben. Das gesamte Steckermodul 2 hängt mithilfe des Lagers 5 in der Haltevorrichtung 6 des Terminalmoduls bzw. der Trägerplatte 3. Das Einsetzen des Elektronikmoduls 1 erfolgt in umgekehrter Reihenfolge. Das Elektronikmodul 1 wird hierbei auf das Steckermodul 2 geschoben und durch Nachobenschwenken des Steckermoduls 2 wird das Elektronikmodul 1 über die Schnittstelle 14 kontaktiert und an der Trägerplatte 3 gehalten. Ein einfaches Wechseln des Elektronikmoduls kann auf diese Weise so erfolgen, dass die Steckverbinder 8 am Steckermodul 2 nicht gelöst werden müssen.

Durch die Schwenkbewegung wird die Baugruppe 1,2, bestehend aus dem Elektronikmodul 1 und dem Steckermodul 2 von dem Busmodul 4 gelöst, wobei auch die Verbindung über die Schnittstelle 14 unterbrochen wird, das Busmodul 14 kann jedoch auch an der Baugruppe 1,2 befestigt bleiben und die Schwenkbewegung ebenfalls mit durchführen.

Die Schwenkbewegung erfolgt als Drehbewegung um den Drehpunkt der Einhängevorrichtung 6 der Trägerplatte. Hier ist das Steckermodul 2 derart eingehängt, dass es in seiner Position an der Trägerplatte 3 stabil bleibt. Beim Schwenkvorgang, der in dem dargestellten Ausführungsbeispiel nach unten erfolgt kommt das Steckermodul 2 den an ihm an den Steckverbindern 8 befestigten Anschlusskabeln entgegen, so dass für das Wechseln der Baugruppe 1,2 bzw. des Elektronikmoduls 1 keine zusätzlichen Kabellängen vorgehalten werden müssen.

Es ist auch vorstellbar, dass die Schwenkbewegung nach oben hin erfolgt und das Steckermodul 2 in einer oberen Position an der Trägerplatte 3 in eine stabile Lage kommt. In diesem Fall würde die Bewegung von oben kommenden Anschlusskabeln entgegen kommen, so dass auch bei dieser Verkabelungsvariante keine Kabellängen für den Wechsel der Baugruppe 1,2 vorgehalten werden müssen.

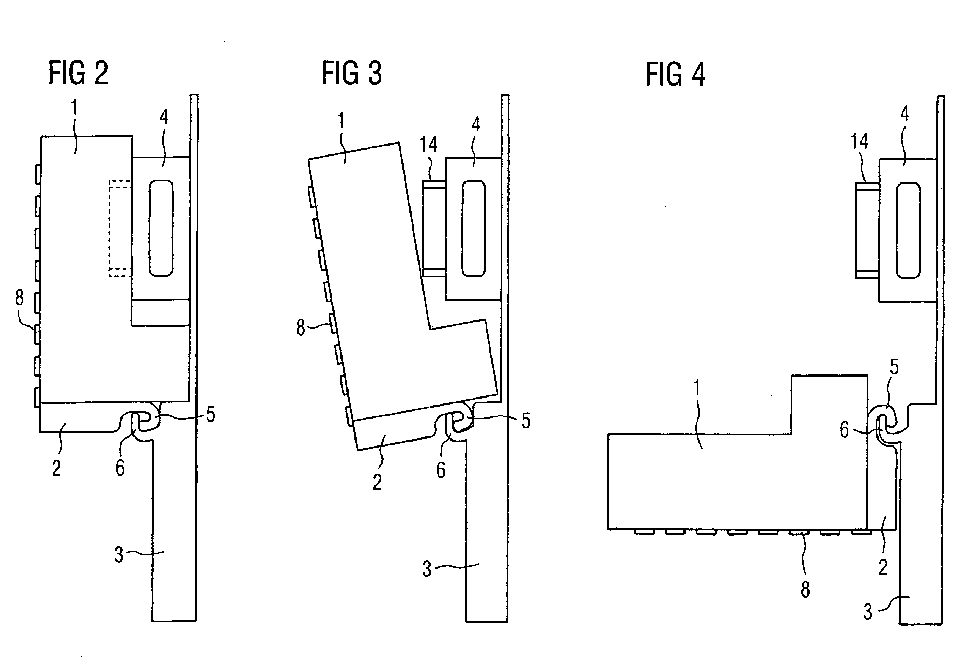

Die Figuren 2 bis 4 zeigen eine Trägerplatte 3 an der eine Baugruppe 1,2 in unterschiedlichen Positionen währen d des Wegschwenkvorganges dargestellt ist. Das Steckermodul 2 hängt mittels eines Lagers 5 in einer Einhängevorrichtung 5 der Trägerplatte 3. In Figur 1 ist die Baugruppe 1,2 vollständig auf die Trägerplatte 3 aufgeschwenkt. In Figur 4 ist die Baugruppe in einer stabilen Endlage nach dem Wegschwenkvorgang gezeigt. In dem dargestellten Ausführungsbeispiel schwenkt die Baugruppe nach unten weg und das Busmodul 4 verbleibt während des Schwenkvorgangs an der Trägerplatte 3. In der stabilen Endposition in Figur 4 kann das Elektronikmodul 1 von dem Steckermodul 2 abgezogen und gewechselt werden.

Die Erfindung betrifft zusammenfassend eine elektrische Baugruppe, eine Trägerplatte und ein System zum einfachen Austausch von Elektronikmodulen der dezentralen Peripherie eines Automatisierungssystems. Die elektrische Baugruppe besteht aus einem Elektronikmodul 1 und einem Steckermodul 2, welche gekoppelt sind. Zum Wechseln der Baugruppe kann das Steckermodul 2 von der Trägerplatte 3 weggeschwenkt werden. Durch die Schwenkbewegung liegt das Elektronikmodul 1 frei auf dem Steckermoduls 2 und kann durch Abziehen gewechselt werden. Das Steckermodul 2 selbst verbleibt an der Trägerplatte 3.

## Patentansprüche

1. System zur Befestigung und/oder zum Austausch einer elektrischen Baugruppe, insbesondere einer Baugruppe einer dezentralen Peripherie eines Automatisierungssystems,
- mit mindestens einer elektrischen Baugruppe bestehend aus einem Elektronikmodul (1) und einem mit dem Elektronikmodul (1) koppelbaren Steckermodul (2) zum Herstellen mindestens einer Steckverbindung und
- mit einer Trägerplatte zur Aufnahme der elektrischen Baugruppe, wobei die Trägerplatte eine Einhängevorrichtung (6) zum Einhängen mindestens eines Steckermoduls (2) aufweist,
wobei das Steckermodul (2) an einem Ende ein Lager (5) zum Einhängen des Steckermoduls (2) in die Einhängevorrichtung (6) der Trägerplatte (3) aufweist, wodurch die elektrische Baugruppe (1,2) von der Trägerplatte (3) um den Drehpunkt der Einhängevorrichtung (6) wegschwenkbar ist,
wobei das Elektronikmodul (1) derart ausgestaltet ist, dass es auf dem Steckermodul (2) aufsitzend während des Schwenkvorgangs am Steckermodul (2) verbleibt und nach Beendigung des Schwenkvorgangs vom Steckermodul (2) abziehbar ist und
wobei das Steckermodul (2) nach Beendigung des Schwenkvorgangs zur Einnahme einer definierten Endposition vorgesehen ist.

2. Elektrische Baugruppe nach Anspruch 1,
**dadurch gekennzeichnet,**
**dass** das Lager (5) des Steckermoduls (2) als Drehlager ausgebildet ist.

3. Elektrische Baugruppe nach einem der Ansprüche 1 oder 2,
**dadurch gekennzeichnet,**
**dass** das Lager (5) des Steckermoduls (2) am unteren Ende des Steckermoduls (2) ausgebildet ist, wodurch die elektrische Baugruppe nach unten von der Trägerplatte (3) wegschwenkbar ist.

## Claims

1. System for securing and/or exchanging an electrical subassembly, in particular a subassembly in the decentralized periphery of an automation system,
- with at least one electrical subassembly comprising an electronics module (1) and a connector module (2) which can be coupled with the electronics module (1) in order to establish at least one plug-in connection and
- with a carrier plate for accommodating the electrical subassembly, whereby the carrier plate has a hooking facility (6) for mounting at least one connector module (2),
whereby the connector module (2) has a bearing (5) at one end for hanging the connector module (2) in the hooking facility (6) on the carrier plate (3), by which means the electrical subassembly (1,2) can be swivelled away from the carrier plate (3) around the pivot point of the hooking facility (6),
whereby the electronics module (1) is designed such that it remains mounted on the connector module (2) during the swivelling process on the connector module (2) and can be withdrawn from the connector module (2) on completion of the swivelling process and
whereby the connector module (2) is intended to assume a defined final position on completion of the swivelling process.

2. Electrical subassembly according to claim 1,
**characterized in that**
the bearing (5) for the connector module (2) is designed as a pivot bearing.

3. Electrical subassembly according to one of claims 1 or 2, **characterized in that**
the bearing (5) for the connector module (2) is formed at the lower end of the connector module (2), as a result of which the electrical subassembly can be swivelled away downwards from the carrier plate (3).

## Revendications

1. Système de fixation et/ou de remplacement d'un module électrique, notamment d'un module d'un périphérique décentralisé d'un système d'automatisation,
- avec au moins un module électrique constitué d'un module électronique (1) et d'un module connecteur (2) pouvant être couplé au module électronique (1) pour établir au moins une connexion à fiches, et
- avec une plaque porteuse pour loger le module électrique, la plaque porteuse comportant un dispositif d'accrochage (6) pour accrocher au moins un module connecteur (2),
le module connecteur (2) comportant à une extrémité un palier (5) pour accrocher le module connecteur (2) dans le dispositif d'accrochage (6) de la plaque porteuse (3), ce qui fait que le module électrique (1, 2) peut être éloigné de la plaque porteuse (3) par pivotement autour du point de rotation du dispositif d'accrochage (6),
le module électronique (1) étant conçu de telle sorte qu'il reste posé sur le module connecteur (2) pendant le pivotement sur le module connecteur (2) et qu'il peut être retiré du module connecteur (2) à la fin du pivotement, et
le module connecteur (2) étant prévu pour prendre à la fin du pivotement une position finale définie.

2. Module électrique selon la revendication 1,
**caractérisé par le fait que** le palier (5) du module connecteur (2) est conçu comme un palier de pivotement.

3. Module électrique selon l'une des revendications 1 ou 2,
**caractérisé par le fait que** le palier (5) du module connecteur (2) est conçu à l'extrémité inférieure du module connecteur (2), ce qui fait que le module électrique peut être éloigné de la plaque porteuse (3) en pivotant vers le bas.
